# EUROPEAN PATENT APPLICATION

(11) **EP 4 644 981 A1**
(43) Date of publication of application: **05.11.2025**
(21) Application number: 25162988.7
(22) Date of filing: 11.03.2025
(51) Int. Cl.: G02F 1/133, G02F 1/1333, G02F 1/137

(54) **COMPOSITE SELF-POWERED DISPLAY DEVICE**

(30) Priority: 01.05.2024 TW 113116264; 01.05.2024 TW 113204408 U
(71) Applicant: Iris Optronics Co., Ltd., Tainan City 711010 (TW)
(72) Inventor: CHEN, Chih Wei, 310021 Zhudong Township (TW); LIAO, Chi Chang, 700022 Tainan City (TW)
(74) Representative: Studio Torta S.p.A.

(57) **Abstract**

A composite self-powered display device (10) includes a display module (100) and a power generation module (200). The display module includes a first transparent substrate (110), a second transparent substrate (120), a first light-transmitting display unit (130) and a second light-transmitting display unit (140) disposed between the first transparent substrate (110) and the second transparent substrate (120), and a non-transparent unit (150) surrounding the first light-transmitting display unit (130) and the second light-transmitting display unit (140). A first light non-transmitting region (132) and a second light non-transmitting region (142) are centrally disposed between the first transparent substrate (110) and the second transparent substrate (120). The power generation module (200) is stacked on the display module (100), and a light penetrates the first transparent substrate (110), at least one of a first light-transmitting region (131) and a second light-transmitting region (141), and the second transparent substrate (120). The power generation module (200) converts the light into electrical energy to provide electrical energy to the first light-transmitting display unit (130) and the second light-transmitting display unit (140).

## Description

### BACKGROUND

### Technical Field

The present disclosure relates to a display device. More particularly, the present disclosure relates to a composite self-powered transparent display device.

### Description of Related Art

With the improvement of display technologies, display styles are emerging increasingly. For example, it has developed from cathode ray tube (CRT) display to liquid crystal display (LCD) and organic light emitting diode (OLED) thin display, and then expanded to LED spliced display. Display functions have evolved from general displays to transparent backgrounds, such as OLED and MicroLED displays. Due to the increase in screen resolution, the demand for the number of light sources has increased, which represents that the total power consumption of displays has shown an increasing trend. Therefore, how to save power or use renewable energy generated by solar power has attracted much attention.

The existing cholesteric liquid crystal display (ChLCD) and MicroLED displays are both transparent and can be integrated with photovoltaic power generation devices. However, how to combine ChLCD and MicroLED with photovoltaic power generation device requires a new panel configuration structure to achieve the synergistic effect of the two displays, and increase the power generation efficiency of the photovoltaic power generation device. In addition, all of the two displays and the photovoltaic power generation device exhibit periodic stripes. If the two displays and the photovoltaic power generation device are combined in a stacked manner, moiré patterns are formed on the image screen easily, which affect the visual quality seriously. In view of this, developing a composite display device with high power generation efficiency and less likely to form moiré patterns has become an urgent problem that related industries want to solve currently.

### SUMMARY

According to one aspect of the present disclosure, a composite self-powered transparent display device includes a display module and a power generation module. The display module includes a first transparent substrate, a second transparent substrate, a first light-transmitting display unit, a second light-transmitting display unit and a non-transparent unit. The second transparent substrate is disposed opposite to the first transparent substrate. The first light-transmitting display unit is disposed between the first transparent substrate and the second transparent substrate, and includes a first light-transmitting region and a first light non-transmitting region. The first light non-transmitting region is connected to the first light-transmitting region. The second light-transmitting display unit is disposed between the first transparent substrate and the second transparent substrate, and includes a second light-transmitting region and a second light non-transmitting region. The second light-transmitting region is adjacent to the first light-transmitting region. The second light non-transmitting region is connected to the second light-transmitting region. The first light non-transmitting region and the second light non-transmitting region are centrally disposed between the first transparent substrate and the second transparent substrate. The non-transparent unit surrounds the first light-transmitting display unit and the second light-transmitting display unit. The power generation module is stacked on the display module. A light penetrates the first transparent substrate, at least one of the first light-transmitting region and the second light-transmitting region and the second transparent substrate sequentially, and enters the power generation module. The power generation module converts the light into an electrical energy to provide the electrical energy to at least one of the first light-transmitting display unit and the second light-transmitting display unit.

According to the composite self-powered transparent display device of the aforementioned aspect, wherein the power generation module includes an energy hunting region for converting the light into the electrical energy, and the energy hunting region overlaps with the first light-transmitting region and the second light-transmitting region.

According to the composite self-powered transparent display device of the aforementioned aspect, wherein the non-transparent unit includes a plurality of signal lines. The signal lines are disposed between the first transparent substrate and the second transparent substrate, and disposed around the first light-transmitting display unit and the second light-transmitting display unit. The first light-transmitting display unit and the second light-transmitting display unit share the signal lines.

According to the composite self-powered transparent display device of the aforementioned aspect, wherein the first light non-transmitting region includes a first switching set electrically connected to the signal lines, and the second light non-transmitting region includes a second switching set electrically connected to the signal lines.

According to the composite self-powered transparent display device of the aforementioned aspect, wherein the first light-transmitting region and the second light-transmitting region have a light-transmitting area, the first light non-transmitting region, the second light non-transmitting region and the non-transparent unit have a light non-transmitting area, the light-transmitting area is A₁, the light non-transmitting area is A₂, and the following condition is satisfied: A₁ / (A₁+A₂) ≥ 50%.

According to the composite self-powered transparent display device of the aforementioned aspect, wherein the first light-transmitting display unit is a reflective light-emitting element, and the second light-transmitting display unit is an active light-emitting element.

According to the composite self-powered transparent display device of the aforementioned aspect, wherein the display module further includes at least one blocking member. The at least one blocking member is disposed between the first light-transmitting region and the second light-transmitting region to separate the first light-transmitting region and the second light-transmitting region.

According to the composite self-powered transparent display device of the aforementioned aspect, wherein the display module further includes a filter layer. The filter layer is disposed between the first transparent substrate and the first light-transmitting region.

According to the composite self-powered transparent display device of the aforementioned aspect, wherein the power generation module is a crystalline silicon solar cell, a thin film solar cell, an organic solar cell (OSC), a perovskite solar cell (PSC) or a dye sensitized solar cell (DSSC).

According to the composite self-powered transparent display device of the aforementioned aspect, wherein the power generation module includes a plurality of power generation units and a plurality of conductive wires. The power generation units are arranged at intervals. Each of the power generation units has a unit length, and a unit spacing is located between two of the power generation units. The conductive wires are arranged at intervals and configured to connect the power generation units in series, and a wire spacing is located between two of the conductive wires. At least one of the unit length, the unit spacing and the wire spacing is greater than or equal to 1 cm.

According to the composite self-powered transparent display device of the aforementioned aspect, wherein the composite self-powered transparent display device further includes a power storage unit. The power storage unit is electrically connected to the first light-transmitting display unit, the second light-transmitting display unit and the power generation module. The power storage unit is configured to store the electrical energy and provide the electrical energy to the at least one of the first light-transmitting display unit and the second light-transmitting display unit.

According to the composite self-powered transparent display device of the aforementioned aspect, wherein the first light non-transmitting region and the second light non-transmitting region are concentrated in a region between the first transparent substrate and the second transparent substrate, and the region is located at a corner inside the non-transparent unit.

According to the composite self-powered transparent display device of the aforementioned aspect, wherein the first transparent substrate includes a first transparent substrate layer and a first transparent electrode layer. The first transparent substrate layer is located on a top of the display module. The first transparent electrode layer is disposed below the first transparent substrate layer and above the first light-transmitting display unit and the second light-transmitting display unit.

According to the composite self-powered transparent display device of the aforementioned aspect, wherein the second transparent substrate includes a second transparent substrate layer and a second transparent electrode layer. The second transparent substrate layer is located on a bottom of the display module and disposed above the power generation module. The second transparent electrode layer is disposed above the second transparent substrate layer and below the first light-transmitting display unit and the second light-transmitting display unit.

According to the composite self-powered transparent display device of the aforementioned aspect, wherein an adhesive layer is disposed between the second transparent substrate and the power generation module.

### BRIEF DESCRIPTION OF THE DRAWINGS

The present disclosure can be more fully understood by reading the following detailed description of the embodiment, with reference made to the accompanying drawings as follows:
Fig. 1 is a top view of a composite self-powered transparent display device according to a first embodiment of the present disclosure.
Fig. 2 is a cross-sectional view of the composite self-powered transparent display device along a tangent line A-A' shown in Fig. 1.
Fig. 3 shows a top view of a power generation module of the composite self-powered transparent display device shown in Fig. 2.
Fig. 4 is a cross-sectional view of a composite self-powered transparent display device according to a second embodiment of the present disclosure.

### DETAILED DESCRIPTION

The embodiment will be described with the drawings. For clarity, some practical details will be described below. However, it should be noted that the present disclosure should not be limited by the practical details, that is, in some embodiment, the practical details is unnecessary. In addition, for simplifying the drawings, some conventional structures and elements will be simply illustrated, and repeated elements may be represented by the same labels.

It will be understood that when an element (or device) is referred to as be "connected" to another element, it can be directly connected to the other element, or it can be indirectly connected to the other element, that is, intervening elements may be present. In contrast, when an element is referred to as be "directly connected to" another element, there are no intervening elements present. In addition, the terms first, second, third, etc. are used herein to describe various elements or components, these elements or components should not be limited by these terms. Consequently, a first element or component discussed below could be termed a second element or component.

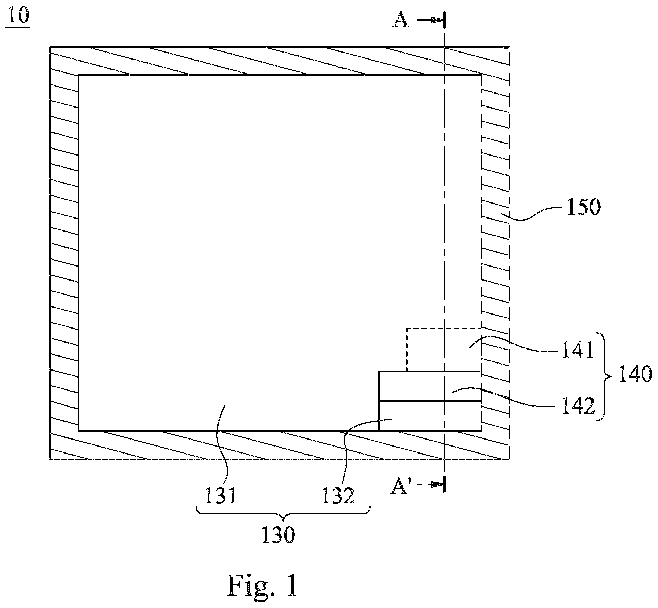

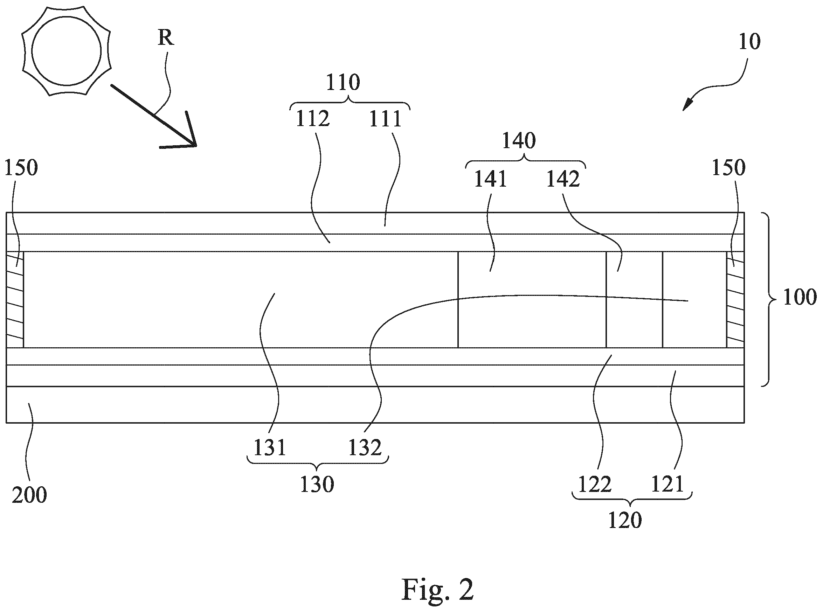

Reference is made to Figs. 1 and 2. Fig. 1 is a top view of a composite self-powered transparent display device according to a first embodiment of the present disclosure. Fig. 2 is a cross-sectional view of the composite self-powered transparent display device along a tangent line A-A' shown in Fig. 1. As shown in Figs. 1 and 2, the composite self-powered transparent display device 10 includes a display module 100 and a power generation module 200.

The display module 100 includes a first transparent substrate 110, a second transparent substrate 120, a first light-transmitting display unit 130, a second light-transmitting display unit 140 and a non-transparent unit 150. The first transparent substrate 110 is disposed opposite to the second transparent substrate 120. The first light-transmitting display unit 130 is disposed between the first transparent substrate 110 and the second transparent substrate 120, and includes a first light-transmitting region 131 and a first light non-transmitting region 132. The first light non-transmitting region 132 is connected to the first light-transmitting region 131. The second light-transmitting display unit 140 is disposed between the first transparent substrate 110 and the second transparent substrate 120, and includes a second light-transmitting region 141 and a second light non-transmitting region 142. The second light non-transmitting region 142 is connected to the second light-transmitting region 141. The first light-transmitting region 131 and the second light-transmitting region 141 are adjacent to each other. The first light non-transmitting region 132 and the second light non-transmitting region 142 are adjacent to each other. The first light non-transmitting region 132 and the second light non-transmitting region 142 are centrally disposed between the first transparent substrate 110 and the second transparent substrate 120. The non-transparent unit 150 surrounds the first light-transmitting display unit 130 and the second light-transmitting display unit 140, and can include a plurality of signal lines. The signal lines are disposed between the first transparent substrate 110 and the second transparent substrate 120, and disposed around the first light-transmitting display unit 130 and the second light-transmitting display unit 140. Therefore, the first light-transmitting display unit 130 and the second light-transmitting display unit 140 can share the signal lines.

The power generation module 200 is stacked on the display module 100; specifically, the power generation module 200 is located beneath the display module 100 (as shown in Fig. 2) and stacked on one side of the display module 100. When light R (e.g., environmental light) penetrates the first transparent substrate 110, at least one of the first light-transmitting region 131 and the second light-transmitting region 141 and the second transparent substrate 120 sequentially and enters the power generation module 200, the power generation module 200 converts the light R into an electrical energy to provide the electrical energy to at least one of the first light-transmitting display unit 130 and the second light-transmitting display unit 140. In some embodiments, the composite self-powered transparent display device 10 can further include a power storage unit (not shown), such as a rechargeable battery. The power storage unit is electrically connected to the first light-transmitting display unit 130, the second light-transmitting display unit 140 and the power generation module 200. The power storage unit receives and stores the electrical energy from the power generation module 200, and provides the electrical energy to the at least one of the first light-transmitting display unit 130 and the second light-transmitting display unit 140.

Thus, based on the structural configuration in which the first light-transmitting display unit 130 and the second light-transmitting display unit 140 are both disposed between the first transparent substrate 110 and the second transparent substrate 120, it means that during the panel manufacturing process, the first light-transmitting display unit 130 and the second light-transmitting display unit 140 share the same transparent substrates (i.e., the first transparent substrate 110 and the second transparent substrate 120), the manufacturing costs of the composite self-powered transparent display device 10 of the present disclosure can be saved, and the overall thickness of the composite self-powered transparent display device 10 can be reduced. In addition, the first light non-transmitting region 132 and the second light non-transmitting region 142 are concentrated in a region between the first transparent substrate 110 and the second transparent substrate 120, and the aforementioned region is located at a corner inside the non-transparent unit 150, thereby reducing the opaque region and enlarging the transparent region in the composite self-powered transparent display device 10. Therefore, an area for allowing the light R to penetrate into the power generation module 200 is maximized, thereby improving the power generation efficiency of the power generation module 200.

In particular, the first transparent substrate 110 can include a first transparent substrate layer 111 and a first transparent electrode layer 112. The first transparent substrate layer 111 is located on the top of the display module 100, and can be a rigid substrate, such as a glass plate or a plate made of polymethyl methacrylate (PMMA), that is, an acrylic plate. Alternatively, the first transparent substrate layer 111 can be a flexible substrate, the main material of which is polyimide (PI) or polyethylene terephthalate (PET). In addition to the materials exemplified above, the first transparent substrate 110 can also be a rigid substrate or a flexible substrate made of other materials. The first transparent electrode layer 112 is disposed below the first transparent substrate layer 111 and above the first light-transmitting display unit 130 and the second light-transmitting display unit 140. The first transparent electrode layer 112 can be made of a transparent conductive material, which can be a transparent conductive oxide (TCO), a conductive polymer or a metal thin film, such as indium tin oxide (ITO), indium zinc oxide (IZO), poly(3,4-ethylenedioxythiophene) (PEDOT), copper metal mesh film or silver nanowire, etc.

The second transparent substrate 120 can include a second transparent substrate layer 121 and a second transparent electrode layer 122. The second transparent substrate layer 121 is located at the bottom of the display module 100 and disposed above the power generation module 200. An adhesive layer (not shown) with high transmittance can be disposed between the second transparent substrate layer 121 and the power generation module 200. The adhesive layer can be composed of optical clear adhesive (OCA). Since a thickness of the adhesive layer is only between tens to hundreds of microns, the thickness can be ignored. Thus, the display module 100 and the power generation module 200 are in close contact with each other. The second transparent electrode layer 122 is disposed above the second transparent substrate layer 121 and below the first light-transmitting display unit 130 and the second light-transmitting display unit 140. In the first embodiment, the material of the second transparent substrate layer 121 is the same as the material of the first transparent substrate layer 111, and the material of the second transparent electrode layer 122 is the same as the material of the first transparent electrode layer 112.

The first light-transmitting display unit 130 can be a reflective light-emitting element, such as a cholesteric liquid crystal display (ChLCD) panel, so the first transparent substrate 110, the first light-transmitting display unit 130 and the second transparent substrate 120 can be regarded as ChLCD. The first light-transmitting region 131 can be a pixel region (i.e., an effective pixel region of ChLCD), which uses the characteristics of cholesteric liquid crystals to reflect the light R to provide an image, and also allows the light R to penetrate to the power generation module 200 located at the bottom of the composite self-powered transparent display device 10. In detail, the light R can be outdoor or indoor ambient light. When the cholesteric liquid crystal in the first light-transmitting region 131 is in a planar mode, the cholesteric liquid crystals are arranged neatly, so that the most of the light R is reflected by the first light-transmitting region 131, but there is still the rest of the light R that can pass through the first light-transmitting region 131 to the power generation module 200. When the cholesteric liquid crystal in the first light-transmitting region 131 is in a focal conic mode, the arrangement of the cholesteric liquid crystals is disordered, and the first light-transmitting region 131 scatters the amount of the light R, so the rest of the light R that can penetrate to the power generation module 200 is increase, resulting in improved power generation efficiency. The driving mode of the first light-transmitting display unit 130 is active. The first light non-transmitting region 132 can include a first switching set electrically connected to the signal lines of the non-transparent unit 150, and the first switching set is composed of a plurality of thin-film transistors (TFTs).

The second light-transmitting display unit 140 can be an active light-emitting element, such as a micro light-emitting diode (MicroLED) panel. Therefore, the first transparent substrate 110, the second light-transmitting display unit 140 and the second transparent substrate 120 can be regarded as a MicroLED display. The second light-transmitting region 141 is a transparent substrate or a transparent plate made of a transparent material, such as an ITO transparent substrate. The second light non-transmitting region 142 can include a second switching set electrically connected to the signal lines of the non-transparent unit 150 and a plurality of LED chips, and the second switching set is composed of another plurality of TFTs.

The non-transparent unit 150 can have a rectangular shape, and its signal lines can be divided into a plurality of scan lines for transmitting scanning signals to the cholesterol liquid crystal and LED chips, and a plurality of data lines for transmitting data signals to the cholesterol liquid crystal and LED chips. In terms of signal transmission distribution, the cholesteric liquid crystal and MicroLED can share the scan lines and/or data lines, which can increase the light aperture ratio of the pixel region, and the signal distribution function can be achieved through external timing controller and drive controller. Further, in the stacked structure of the conventional composite display device, multiple scan lines and data lines exhibit periodic stripes, which form moiré patterns on the image easily, thereby degrading visual quality. However, by sharing the scan lines and/or data lines, the non-transparent unit 150 of the present disclosure surrounds the first light-transmitting display unit 130 and the second light-transmitting display unit 140 to avoid the image displayed by the first light-transmitting region 131 and the second light-transmitting region 141, thereby effectively reducing the chance of moiré pattern formation and ensuring the high image quality of the composite self-powered transparent display device 10.

Furthermore, the first light-transmitting region 131 and the second light-transmitting region 141 can have a light-transmitting area, and the first light non-transmitting region 132, the second light non-transmitting region 142 and the non-transparent unit 150 can have a light non-transmitting area. The total area of the light-transmitting area and the light non-transmitting area is equal to the overall area of the composite self-powered transparent display device 10. The light-transmitting area is represented by A₁, the light non-transmitting area is represented by A₂, and the following condition is satisfied: A₁ / (A₁+A₂) ≥ 50%, and preferably, A₁ / (A₁+A₂) ≥ 90%. The light-transmitting area for the light R to penetrate into the power generation module 200 occupies more than half of the overall area of the composite self-powered transparent display device 10, so that the composite self-powered transparent display device 10 has the functions of active light-emitting and trans-reflective light-emitting; at the same time, the light R can be utilized by the power generation module 200 at the bottom of the composite self-powered transparent display device 10, which can not only reduce the reflected light but also improve the readability under strong light. On the other hand, the composite self-powered transparent display device 10 can use the power generation module 200 at the bottom to perform photoelectric conversion to have self-generated effect and achieve energy saving effect.

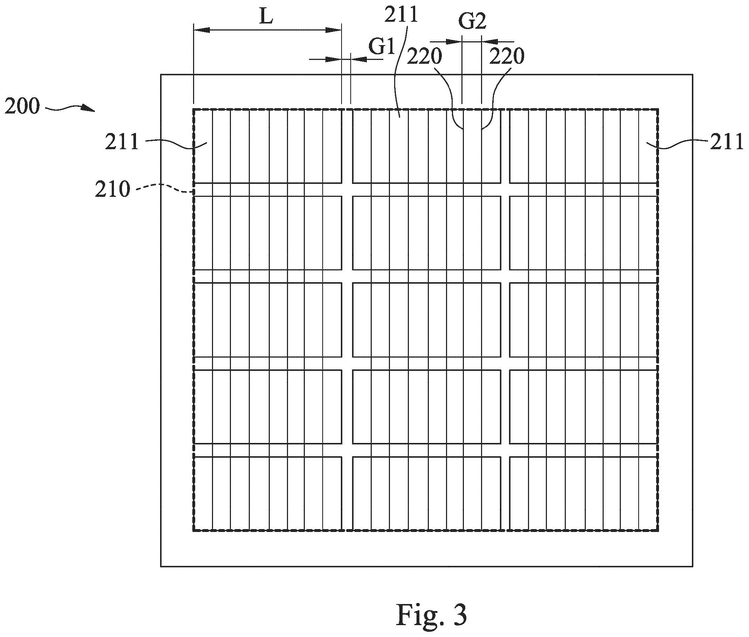

Reference is made to Fig. 3. Fig. 3 shows a top view of a power generation module of the composite self-powered transparent display device shown in Fig. 2. As shown in Fig. 3, the power generation module 200 can be, for example, but not limited to a crystalline silicon solar cell, a thin film solar cell, an organic solar cell (OSC), a perovskite solar cell (PSC) or a dye sensitized solar cell (DSSC), or other solar cells that can convert ambient light into the electrical energy. The power generation module 200 can include an energy hunting region 210 for converting the light R into the electrical energy. The energy hunting region 210 is an effective power generation region of the power generation module 200. The effective power generation region actually refers to a region with the light-to-electricity conversion function, which needs to exclude non-power generation region (such as an insulation region, a prohibited region, and a wire region). The energy hunting region 210 includes a plurality of power generation units 211 arranged in an array, and each of the power generation units 211 can be a solar cell. The energy hunting region 210 can completely overlap or partially overlap with the first light-transmitting region 131 and the second light-transmitting region 141. If the energy hunting region 210 completely overlaps with the first light-transmitting region 131 and the second light-transmitting region 141, the effective power generation region that absorbs the light R can be maximized, thereby improving the power generation efficiency. The aforementioned wire region can transmit the current (corresponding to the electrical energy) generated by the energy hunting region 210 to the first light-transmitting display unit 130, the second light-transmitting display unit 140 or an external circuit coupled thereto.

In Fig. 3, the power generation units 211 of the energy hunting region 210 are arranged at intervals from each other. Each of the power generation units 211 has a unit length L. A unit spacing G1 is located between two of the power generation units 211 that are spaced apart from each other. In addition, the power generation module 200 can further include a plurality of conductive wires 220. The conductive wires 220 are arranged at intervals and configured to connect the power generation units 211 of the energy hunting region 210 in series. A wire spacing G2 is located between two of the conductive wires 220. At least one of the unit length L, the unit spacing G1 and the wire spacing G2 is greater than or equal to 1 cm. In detail, both the power generation unit 211 and the conductive wire 220 exhibit periodic stripes, and even the insulation region used to electrically isolate the power generation units 211 also exhibits periodic stripes. The common pixel size of the general display is between 50 and 300 microns (µm), and 3 to 17 pixels can be seen at the viewing angle of 1 degree at the normal viewing distance (such as 50 cm). Thus, based on the specific periodic spacing design of the power generation module 200 (for example, as long as the unit length L, the unit spacing G1 and the wire spacing G2 are controlled above 1 cm), the vision contrast of the periodic stripes is less than 0.55, and the sensitivity of human vision to moiré patterns is reduced, thereby preventing the power generation module 200 from causing fringe spatial interference on the first light-transmitting display unit 130 and the second light-transmitting display unit 140, and reducing the probability of the moiré effect.

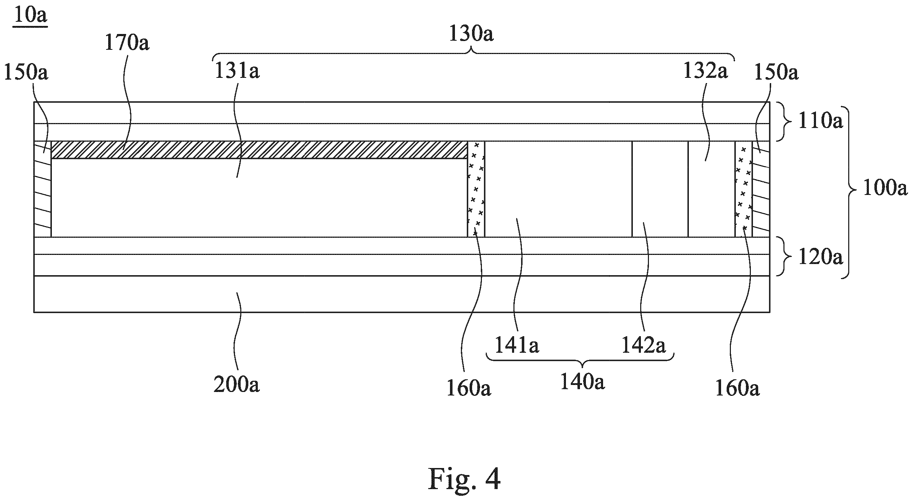

Reference is made to Fig. 4. Fig. 4 is a cross-sectional view of a composite self-powered transparent display device according to a second embodiment of the present disclosure. As shown in Fig. 4, the composite self-powered transparent display device 10a includes a display module 100a and a power generation module 200a. The display module 100a includes a first transparent substrate 110a, a second transparent substrate 120a, a first light-transmitting display unit 130a, a second light-transmitting display unit 140a and a non-transparent unit 150a. Each component of the composite self-powered transparent display device 10a is the same as the corresponding component in the composite self-powered transparent display device 10 in Fig. 2, so their detailed structures and functions are not described again herein.

The difference from Fig. 2 is that the display module 100a can further include at least one blocking member 160a. In the second embodiment, the number of the at least one blocking member 160a can be two. One of the blocking members 160a is disposed between the first light-transmitting region 131a and the second light-transmitting region 141a to separate the first light-transmitting region 131a and the second light-transmitting region 141a. The other of the blocking members 160a is disposed around the first light non-transmitting region 132a and the second light non-transmitting region 142a. In detail, the blocking member 160a can be a photo spacer (PS). In order to reduce the usage of cholesteric liquid crystal and prevent the cholesteric liquid crystal from overflowing into MicroLED that affects brightness of the active light-emitting element, the display module 100a of the present disclosure is configured with photo spacers around the MicroLED and TFTs regions to prevent the cholesterol liquid crystal in the first light-transmitting region 131a from overflowing to the second light-transmitting region 141a, the second light non-transmitting region 142a and the first light non-transmitting region 132a.

Moreover, the display module 100a can further include a filter layer 170a, which can be a mono color filter layer. The filter layer 170a is disposed between the first transparent substrate 110a and the first light-transmitting region 131a. For applications with high color saturation requirements, MicroLED can provide RGB light sources with narrow spectrum and easily meet the requirements of color space. However, cholesteric liquid crystals mainly rely on reflecting ambient light to provide color images. In order to achieve better color space performance under a very broad spectrum light source (such as sunlight), the present disclosure adds the filter layer 170a to the panel manufacturing process of the display module 100a. The filtering effect of the filter layer 170a can be matched with the reflection spectrum of the cholesteric liquid crystals in the first light-transmitting region 131a to make the color of the image more saturation.

According to the aforementioned embodiments and examples, the advantages of the composite self-powered transparent display device of the present disclosure are described as follows.
1. Compared with the existing two-panel stacked structure, it saves manufacturing costs and reduces the thickness of the composite self-powered transparent display device. In addition, during the panel manufacturing process, the first light-transmitting display unit and the second light-transmitting display unit share the same transparent substrate, which facilitates manufacturing processes of TFTs.
2. Cholesterol LCD and MicroLED share scan lines and/or data lines, which can increase the light aperture ratio of the pixel region.
3. Concentrating the TFTs that drive cholesteric liquid crystals and MicroLEDs in the same region is conducive to minimizing the non-transparent region; in other words, it is beneficial to increase light transmittance and improve power generation efficiency.
4. By sharing the scan lines and/or data lines, the scan lines and/or data lines surround the first light-transmitting display unit and the second light-transmitting display unit, thereby effectively suppressing the formation of moiré patterns and ensuring picture quality.
5. The composite self-powered transparent display device has the functions of active light-emitting and trans-reflective light-emitting to realize two different display technologies, and can use the power generation module to perform photoelectric conversion to achieve the self-generated effect.

## Claims

1. A composite self-powered transparent display device (10), **characterized in** comprising:
a display module (100), comprising:
a first transparent substrate (110);
a second transparent substrate (120) disposed opposite to the first transparent substrate (110);
a first light-transmitting display unit (130) disposed between the first transparent substrate (110) and the second transparent substrate (120), and comprising:
a first light-transmitting region (131); and
a first light non-transmitting region (132) connected to the first light-transmitting region (131);
a second light-transmitting display unit (140) disposed between the first transparent substrate (110) and the second transparent substrate (120), and comprising:
a second light-transmitting region (141) adjacent to the first light-transmitting region (131); and
a second light non-transmitting region (142) connected to the second light-transmitting region (141), wherein the first light non-transmitting region (132) and the second light non-transmitting region (142) are centrally disposed between the first transparent substrate (110) and the second transparent substrate (120); and
a non-transparent unit (150) surrounding the first light-transmitting display unit (130) and the second light-transmitting display unit (140); and
a power generation module (200) stacked on the display module (100), wherein a light (R) penetrates the first transparent substrate (110), at least one of the first light-transmitting region (131) and the second light-transmitting region (141) and the second transparent substrate (120) sequentially and enters the power generation module (200), and the power generation module (200) converts the light (R) into an electrical energy to provide the electrical energy to at least one of the first light-transmitting display unit (130) and the second light-transmitting display unit (140).

2. The composite self-powered transparent display device (10) of claim 1, wherein the power generation module (200) comprises an energy hunting region (210) for converting the light (R) into the electrical energy, and the energy hunting region (210) overlaps with the first light-transmitting region (131) and the second light-transmitting region (141).

3. The composite self-powered transparent display device (10) of any of claims 1-2, wherein the non-transparent unit (150) comprises:
a plurality of signal lines disposed between the first transparent substrate (110) and the second transparent substrate (120), and disposed around the first light-transmitting display unit (130) and the second light-transmitting display unit (140), wherein the first light-transmitting display unit (130) and the second light-transmitting display unit (140) share the signal lines.

4. The composite self-powered transparent display device (10) of any of claims 1-3, wherein the first light non-transmitting region (132) comprises a first switching set electrically connected to the signal lines, and the second light non-transmitting region (142) comprises a second switching set electrically connected to the signal lines.

5. The composite self-powered transparent display device (10) of any of claims 1-4, wherein the first light-transmitting region (131) and the second light-transmitting region (141) have a light-transmitting area, the first light non-transmitting region, the second light non-transmitting region and the non-transparent unit have a light non-transmitting area, the light-transmitting area is A₁, the light non-transmitting area is A₂, and the following condition is satisfied:
A₁ / (A₁+A₂) ≥ 50%.

6. The composite self-powered transparent display device (10) of any of claims 1-5, wherein the first light-transmitting display unit (130) is a reflective light-emitting element, and the second light-transmitting display unit (140) is an active light-emitting element.

7. The composite self-powered transparent display device (10a) of any of claims 1-6, wherein the display module (100a) further comprises:
at least one blocking member (160a) disposed between the first light-transmitting region (131a) and the second light-transmitting region (141a) to separate the first light-transmitting region (131a) and the second light-transmitting region (141a).

8. The composite self-powered transparent display device (10a) of any of claims 1-7, wherein the display module (100a) further comprises:
a filter layer (170a) disposed between the first transparent substrate (110a) and the first light-transmitting region (131a).

9. The composite self-powered transparent display device (10) of any of claims 1-8, wherein the power generation module (200) is a crystalline silicon solar cell, a thin film solar cell, an organic solar cell (OSC), a perovskite solar cell (PSC) or a dye sensitized solar cell (DSSC).

10. The composite self-powered transparent display device (10) of any of claims 1-9, wherein the power generation module (200) comprises:
a plurality of power generation units (211) arranged at intervals, wherein each of the power generation units (211) has a unit length (L), and a unit spacing (G1) is located between two of the power generation units (211); and
a plurality of conductive wires (220) arranged at intervals and configured to connect the power generation units (211) in series, wherein a wire spacing (G2) is located between two of the conductive wires (220);
wherein at least one of the unit length (L), the unit spacing (G2) and the wire spacing (G3) is greater than or equal to 1 cm.

11. The composite self-powered transparent display device (10) of any of claims 1-10, further comprising:
a power storage unit electrically connected to the first light-transmitting display unit (130), the second light-transmitting display unit (140) and the power generation module (200), wherein the power storage unit is configured to store the electrical energy and provide the electrical energy to the at least one of the first light-transmitting display unit (130) and the second light-transmitting display unit (140).

12. The composite self-powered transparent display device (10) of any of claims 1-11, wherein the first light non-transmitting region (132) and the second light non-transmitting region (142) are concentrated in a region between the first transparent substrate (110) and the second transparent substrate (120), and the region is located at a corner inside the non-transparent unit (150).

13. The composite self-powered transparent display device (10) of any of claims 1-12, wherein the first transparent substrate (110) comprises:
a first transparent substrate layer (111) located on a top of the display module (100); and
a first transparent electrode layer (112) disposed below the first transparent substrate layer (111) and above the first light-transmitting display unit (130) and the second light-transmitting display unit (140).

14. The composite self-powered transparent display device (10) of any of claims 1-13, wherein the second transparent substrate (120) comprises:
a second transparent substrate layer (121) located on a bottom of the display module (100) and disposed above the power generation module (200); and
a second transparent electrode layer (122) disposed above the second transparent substrate layer (121) and below the first light-transmitting display unit (130) and the second light-transmitting display unit (140).

15. The composite self-powered transparent display device (10) of any of claims 1-14, wherein an adhesive layer is disposed between the second transparent substrate (121) and the power generation module (200).
